Europäisches Patentamt

European Patent Office

Office européen des brevets

(19)

(11) Veröffentlichungsnummer: **0 125 586 B1**

(12) ## EUROPÄISCHE PATENTSCHRIFT

(45) Veröffentlichungstag der Patentschrift: **26.06.91**

(51) Int. Cl.⁵: **H03B 5/12**

(21) Anmeldenummer: **84105078.4**

(22) Anmeldetag: **05.05.84**

(54) **Oszillatorschaltung für Fernsehempfangsgeräte.**

(30) Priorität: **07.05.83 DE 3316881**

(43) Veröffentlichungstag der Anmeldung:
**21.11.84 Patentblatt 84/47**

(45) Bekanntmachung des Hinweises auf die
Patenterteilung:
**26.06.91 Patentblatt 91/26**

(84) Benannte Vertragsstaaten:
**FR GB IT LU**

(56) Entgegenhaltungen:
DE-A- 2 816 786       DE-A- 2 918 636
DE-A- 2 929 897       DE-A- 3 017 607
DE-B- 2 701 353       DE-B- 2 846 411

PATENT ABSTRACTS OF JAPAN, Band 7, Nr.
194 (E-195)[1339], 24. August 1983; & JP - A -
58 95419 (MATSUSHITA DENKI SANGYO)
07.06.1983 (Kat. A)

(73) Patentinhaber: **Deutsche Thomson-Brandt
GmbH**
**Hermann-Schwer-Strasse 3 Postfach 1307**
**W-7730 Villingen-Schwenningen(DE)**

(72) Erfinder: **Maier, Gerhard**
**Reutestrasse 19**
**W-7735 Dauchingen(DE)**
Erfinder: **Kirschner, Erich**
**Drosselstrasse 10**
**W-7210 Göllsdorf(DE)**

EP 0 125 586 B1

## Beschreibung

Eine Oszillatorschaltung in einem Fernsehempfangsgerät dient bekanntlich dazu, mit Hilfe der von dieser erzeugten Frequenzen in einer Mischstufe die konstante Zwischenfrequenz zu bilden. Dazu muß der Oszillator in seiner Frequenz immer derart abgestimmt sein, daß diese um die Zwischenfrequenz höher liegt als die gewünschte Eingangsfrequenz. Hierbei kommt es darauf an, daß ein möglichst großer Frequenzbereich überstrichen wird, insbesondere wenn ein Kabeltuner mit einem großen Empfangsbereich aufgebaut werden soll. Im allgemeinen werden derartige Oszillatoren in Basisgrundschaltung angewendet, die einen großen Frequenzbereich überstreichen können. Diese haben jedoch den Nachteil, daß die Amplitude der erzeugten Oszillatorschwingungen großen Schwankungen unterworden ist.

In der DE-B-27 01 353 wird eine Mischstufe beschrieben, bei welcher der Oszillator in einer Basisgrundschaltung aufgebaut ist. Zur Erzielung eines großen Frequenzvariationsbereichs wird hier die Rückkopplung des Oszillators mit Hilfe einer von der Abstimmspannung gesteuerten Kapazitätsdiode veränderbar. Aber auch bei einer derartigen Anordnung ist eine absolute Amplitudenkonstanz über den gesamten zu überstreichenden Frequenzbereich nicht gewährleistet.

Mit einer Oszillatorschaltung in Kollektorgrundschaltung dagegen erzielt man den großen Vorteil, daß die Amplitude der erzeugten Oszillatorschwingungen weitgehend konstant ist. Diese wird jedoch wieder mit dem Nachteil erkauft, daß durch die große kapazitive Belastung des Basis-Emitter-Teilers die breiten Kabelfrequenzbereiche nicht mehr durchstimmbar sind.

Der Erfindung liegt deshalb die Aufgabe zugrunde, den Vorteil der Amplitudenkonstanz einer in Kollektorgrundschaltung aufgebauten Oszillatorschaltung mit einem größtmöglichen Frequenzvariationsbereich zu kombinieren. Diese Aufgabe wird durch die Maßnahmen des Patentanspruchs gelöst.

Die Erfindung besteht darin, daß die hohe Amplitudenkonstanz durch die Kombination einer in Kollektorgrundschaltung betriebenen Oszillatorschaltung mit einer durch eine dritte Kapazitätsdiode von der Abstimmung abhängigen Rückkopplung erreicht wird, indem das kapazitive Spannungsteilerverhältnis im Rückkopplungszweig und damit der Rückkopplungsfaktor verändert wird.

Die Basis des Transistors 1 ist mit Hilfe des aus den Widerständen 4 und 5 bestehenden Spannungsteilers, der zwischen der Versorgungsspannung $^+$ UB und Masse liegt, vorgespannt. Im Eingang liegt zwischen Basis und Masse ein aus dem Kondensator 6 und 7 sowie einer Kapazitätsdiode 8 bestehender kapazitiver Spannungsteiler, wobei die Verbindung zwischen den Kondensatoren 6 und 7 mit dem Emitter des Transitors 1 zusammengeschaltet ist. Die Oszillatorschwingungen werden vom Kollektor über einen Kondensator 21 ausgekoppelt. Der Schwingkreis der Oszillatorschaltung besteht aus den Induktivitäten 9 und 10, wobei die Induktivität 10 mit Hilfe einer durch eine Schaltspannung US über einen Vorwiderstand 11 einschaltbare Diode 12 zwecks Bandumschaltung kurzschließbar ist. Zu dem Schwingkreis gehören weiter eine parallel zu den Induktivitäten 9 und 10 geschaltete Abstimmdiode 13 in Serie zu einer festen Kapazität eines Kondensators 14 und zu einer Spule 15. Der Oszillatorschwingkreis ist über einen Kondensator 16 an den Eingang des Transistors angekoppelt. Zwischen dem Schwingkreis und dem Koppelkondensator 16 ist eine weitere Kapazitätsdiode 17 geschaltet. Die Kapazitätsdioden 8, 13 und 17 werden gleichzeitig und parallel über Vorwiderstände 18, 19 und 20 mit Hilfe der Abstimmspannung UT beaufschlagt. Die Vergrößerung des Frequenzvariationsbereichs entsteht durch die Einschaltung der beiden Kapazitätsdioden 8 und 17 dadurch, daß die dem Schwingkreis parallelgeschaltete Kapazität sowie die Eingangsimpedanz des Transistors 1 in Abrängigkeit von der Frequenz und damit in Abhängigkeit von der Abstimmspannung

UT sinnvoll verändert und angepaßt wird. Bei tiefen Frequenzen, d. h. bei niedriger Abstimmspannung, besitzen die Kapazitätsdioden 8 und 17 große Werte. Bei hohen Frequenzen, d. h. bei höheren Abstimmspannungswerten UT werden die Kapazitätswerte mitlaufend immer kleiner, so daß der Kreis auf höhere Frequenzen abstimmbar ist, da die kapazitive Belastung vermindert wird. Das wirkt sich praktisch derart aus, daß der Frequenzvariationsbereich von bisher 110 MHz bis 260 MHz nunmehr auf 110 MHz bis 300 MHz ansteigt.

Mit der beschriebenen Schaltung wird durch die Dioden 17 und 8 die kapazitive Belastung bei jeder Frequenz transformiert.

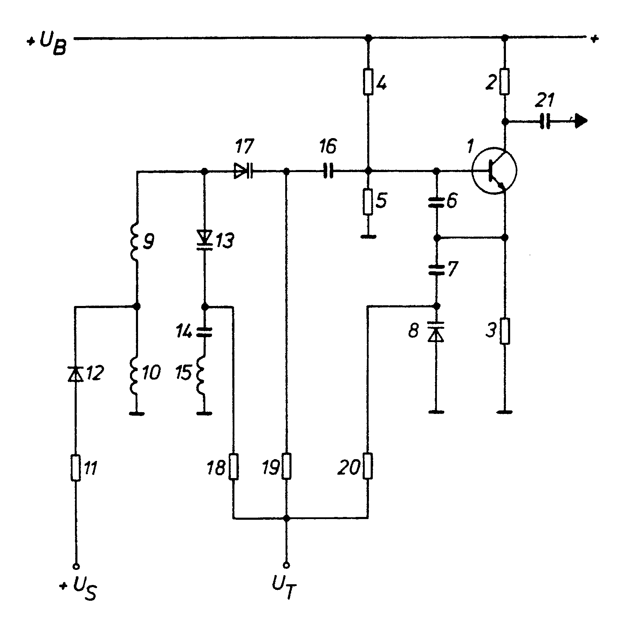

## Ansprüche

1. Oszillatorschaltung für Fernsehempfangsgeräte mit Kapazitätsdiodenabstimmung mit einem Transistor (1) in Kollektorgrundschaltung, dessen Basis über einen kapazitiven Spannungsteiler (6,7,8) und dessen Emitter über einen Widerstand (3) mit Bezugspotential und der Emitter mit dem Teilerpunkt des kapazitiven Spannungsteilers verbunden ist, wobei der abstimmbare, auf verschiedene Frequenzbänder umschaltbare Oszillatorshwingkreis (9,10,13,14,15) über einen Kondensator (16) die Basis des Transistors angekoppelt und die Kapazitätsdiod (13) des Oszillatorschwingeises mit Hilfe einer über einen Vorwiderstand (16) zugeführten Spannung (UT) abstimmbar ist, **dadurch gekennzeichnet,** daß in Serie zur Ankoppelkapazität (16) zwischen dieser un dem Oszillatorschwingkreis (9, 10, 13, 14, 15) eine zweite Kapazitätsdiode (17) sowie in den einen Teil des kapazitiven Spannungsteilers eine dritte Kapazitätsdiode (8) geschaltet ist, wobei die Dioden (8, 17) über Vorwiderstände (19, 20) an die Abstimmspannung (UT) gelegt sind.

## Claims

1. An oscillator circuit for television receiving devices with capacitance diode tuning having a transistor (1) in grounded-collector connection, the base of the transistor being connected via a capacitive voltage divider (6,7,8) and its emitter being connected via a resistor (3) with reference potential and the emitter with the divider point of the capacitive voltage divider, in which the tunable oscillator resonant circuit (9,10,13,14,l5) which may be switched over to different frequency bands is coupled to the base of the transistor via a capacitor (16) and the capacitance diode (13) of the oscillator resonant circuit is tunable with the aid of a voltage (UT) supplied via a series resistor (16), **characterized in that** in series with the coupling capacitance (16) between this and the oscillator resonant circuit (9,10,13,14,15) there is connected a second capacitance diode (17) and in one part of the capacitive voltage divider there is connected a third capacitance diode (8), in which the diodes (8, 17) are applied via series resistors (19, 20) to the tuning voltage (UT).

## Revendications

1. Circuit d'oscillateur pour des recepteurs de television avec accord par diode a capacite variable comportant un transistor (1) dans un montage a collecteur commun dont la base est rellee par un diviseur de tension capacitif (6, 7, 8) et l'emetteur par une resistance (3) au potentiel de référence et l'émetteur au point de division du diviseur de tension capacitif, le circuit oscillant de l'oscillateur (9, 10, 13, 14, 15) accordable et commutabie sur différentes bandes de fréquence par un condensateur (16) etant accouple a la base au transistor et la diode a capacite variable (13) du circuit oscillant de l'oscillateur etant accordable à l'aide d'une tension (UT) fournie par une résistance serie (18), caracterisé en ce qu'une deuxieme diode a capacite variable (17) est montée en série au condensateur de couplage (16) entre ce dernier et le circuit oscillant de l'oscillateur (9, 10, 13, 14, 15) ainsi qu'une troisième diode à capacite variable (8) dans une partie du diviseur de tension capacitif, les diodes (8, 17) étant reliées à la tension d'accord (UT) par des resistances serie (19, 20).